# EUROPEAN PATENT APPLICATION

(11) **EP 4 552 786 A1**
(43) Date of publication of application: **14.05.2025**
(21) Application number: 23852949.9
(22) Date of filing: 08.08.2023
(51) Int. Cl.: B23K 26/359, B23K 26/0622, H04M 1/02, H05K 5/02, H05K 5/00

(54) **ELECTRONIC DEVICE COMPRISING HOUSING WITH PATTERN, AND METHOD FOR FORMING PATTERN**

(30) Priority: 08.08.2022 KR 20220098416; 30.09.2022 KR 20220125711
(71) Applicant: Samsung Electronics Co., Ltd., Suwon-si, Gyeonggi-do 16677 (KR)
(72) Inventor: LIM, Jiwoon, Suwon-si, Gyeonggi-do 16677 (KR); KIM, Juree, Suwon-si, Gyeonggi-do 16677 (KR); KIM, Hakju, Suwon-si, Gyeonggi-do 16677 (KR); PARK, Gijea, Suwon-si, Gyeonggi-do 16677 (KR); BYEON, Junki, Suwon-si, Gyeonggi-do 16677 (KR); SHIN, Wanju, Suwon-si, Gyeonggi-do 16677 (KR); CHOI, Jongmun, Suwon-si, Gyeonggi-do 16677 (KR); CHOI, Hyunsuk, Suwon-si, Gyeonggi-do 16677 (KR)
(74) Representative: Appleyard Lees IP LLP
(86) International application number: PCT/KR2023/011680
(87) International publication number: WO 2024/035078

(57) **Abstract**

According to one embodiment, an electronic device may comprise a housing. According to one embodiment, an electronic device may comprise a glass layer formed on the rear surface of the housing. According to one embodiment, an electronic device may comprise a concave-convex layer, which is formed on the glass layer and includes a plurality of grooves. According to one embodiment, a nanosecond laser beam is emitted at partial grooves from among the plurality of grooves so that at least one pattern can be carved on the concave-convex layer. According to one embodiment, the emitted nanosecond laser beam can be reflected and absorbed in multiple ways at the inner walls of the partial grooves from among the plurality of grooves. Other various embodiments identified through the specification are possible.

## Description

### [Technical Field]

Various embodiments disclosed in this document relate to an electronic device including a housing in which a pattern is formed, and a method for forming the pattern.

### [Background Art]

An electronic device such as a smartphone or a tablet PC can include a housing forming the exterior. The housing can be formed mainly of a metal or plastic material.

The housing forming the exterior of the electronic device can be formed with various colors and designs. For example, the housing can include a design including various colors and various patterns. Since the housing includes various colors and various patterns, the electronic device can increase the usability of a user who uses the electronic device.

The housing of the electronic device can have a pattern or design formed in a surface, to provide an aesthetic feeling to the user. For example, a pattern including a manufacturer's name of the electronic device can be formed in a rear cover of the electronic device. Or, various characters can be formed in the rear cover of the electronic device.

### [Disclosure of Invention]

### [Solution to Problem]

According to an embodiment, an electronic device may include a housing. According to an embodiment, the electronic device may include a glass layer formed on a rear surface of the housing. According to an embodiment, the electronic device may include a concave-convex layer formed on the glass layer and including a plurality of grooves. According to an embodiment, a nano-second laser beam may be radiated to partial grooves among the plurality of grooves, thereby carving at least one pattern on the concave-convex layer. According to an embodiment, the radiated nano-second laser beam may be multi-reflected and multi-absorbed on the inner walls of the partial grooves among the plurality of grooves.

According to an embodiment, a method for forming a pattern on a housing of an electronic device may include preparing a glass layer formed on the housing. According to an embodiment, the method for forming the pattern on the housing of the electronic device may include forming a concave-convex layer including a plurality of grooves on the glass layer. According to an embodiment, the method for forming the pattern on the housing of the electronic device may include radiating a nano-second laser beam to the plurality of grooves and forming at least one pattern on the concave-convex layer. According to an embodiment, the at least one pattern may be formed by the nano-second laser beam multi-reflected and multi-absorbed on an inner wall of each of partial grooves among the plurality of grooves.

### [Brief Description of Drawings]

FIG. 1 is a front perspective view of an electronic device according to an embodiment.
FIG. 2 is a rear perspective view of an electronic device according to an embodiment.
FIG. 3 illustrates at least one pattern formed in a rear surface of an electronic device according to an embodiment.
FIG. 4A illustrates a plurality of grooves of a concave-convex layer according to an embodiment.
FIG. 4B illustrates a plurality of grooves of a concave-convex layer according to an embodiment.
FIG. 5 is a flowchart illustrating the process of forming at least one pattern according to an embodiment.
FIG. 6 illustrates a concave-convex layer according to an embodiment.
FIG. 7 illustrates a heat affected zone formed on a concave-convex layer according to an embodiment.
FIG. 8A illustrates a laminated structure of a glass layer and a concave-convex layer according to an embodiment.
FIG. 8B illustrates at least one pattern formed on a concave-convex layer according to an embodiment.
FIG. 9A illustrates a laminated structure of a glass layer and a concave-convex layer according to an embodiment.
FIG. 9B illustrates at least one pattern according to an embodiment.
FIG. 10 illustrates a laminated structure of a glass layer and a concave-convex layer according to an embodiment.
FIG. 11A illustrates a laminated structure of a glass layer and a concave-convex layer according to an embodiment.
FIG. 11B illustrates at least one pattern according to an embodiment.
FIG. 12 illustrates a laminated structure of a glass layer and a concave-convex layer according to an embodiment.
FIG. 13 is a block diagram of an electronic device in a network environment according to an embodiment.

In relation with the description of the drawings, the same or similar reference numerals may be used for the same or similar components.

### [Mode for the Invention]

Various embodiments of the disclosure are described below with reference to the accompanying drawings. However, these are not intended to limit the disclosure to specific embodiment forms, and should be understood as including various modifications, equivalents, and/or alternatives of the embodiments of the disclosure.

According to an embodiment, a glass layer may be formed on a rear surface of an electronic device. In addition, various patterns may be carved on the glass layer formed on the rear surface of the electronic device.

The various patterns formed on the glass layer may be formed by various methods. For example, the various methods may include a blasting method, a thermal molding method, a computer numerical control (CNC) method, and a laser method.

However, the process of the blasting method, the thermal molding method, and the CNC method may additionally require auxiliary materials and consumables. When the additional auxiliary materials and consumables are provided, a lot of time and a lot of cost may be required during the process.

In addition, the laser method may include a method using a nano-second laser beam and a method using a pico-second or femto-second laser beam.

Generally, the glass used on the rear surface of the electronic device may be used as glass having a high light transmittance, a low light reflectance, and a low light absorption, in order to implement a clear color feeling on the electronic device.

However, in the method using the nano-second laser beam, when a pattern is carved on glass having a low light absorption and a high light transmittance, the sharpness of the pattern may decrease and a lot of time may be required during the process.

In addition, in the method using the pico-second laser beam or femto-second laser beam, the sharpness of the pattern may increase and a process time may decrease, but a process cost may increase, practicality may reduce and commercialization may be difficult.

According to an embodiment, at least one pattern with improved sharpness may be carved using the nano-second laser beam.

According to an embodiment, as the at least one pattern is formed by the nano-second laser beam, the provision of auxiliary materials and consumables may be reduced. For example, since the nano-second laser beam is used, the provision of consumables and auxiliary materials used in a CNC process and a blasting process may be reduced. As the provision of additional consumables and auxiliary materials is reduced, an environmentally friendly pattern process may be implemented.

According to an embodiment, as the at least one pattern is formed by the nano-second laser beam, a process cost may be reduced compared to when the at least one pattern is formed by the picosecond laser beam or the femtosecond laser beam. The process cost is reduced, whereby practicality may be increased and commercialization may be facilitated.

According to an embodiment, a process using a concave-convex layer including a plurality of grooves when carving the at least one pattern by using the nano-second laser beam may have a reduced working time compared to the process of carving the at least one pattern on a layer not including the plurality of grooves. The process using the concave-convex layer including the plurality of grooves may improve the visibility of the at least one pattern compared to the process of carving the at least one pattern on the layer not including the plurality of grooves.

According to an embodiment, the concave-convex layer including the plurality of grooves may be formed, whereby the at least one pattern with the improved visibility may be formed even on the glass having a low reflectance and a low absorption by the multi-absorption and multi-reflection of the nano-second laser beam.

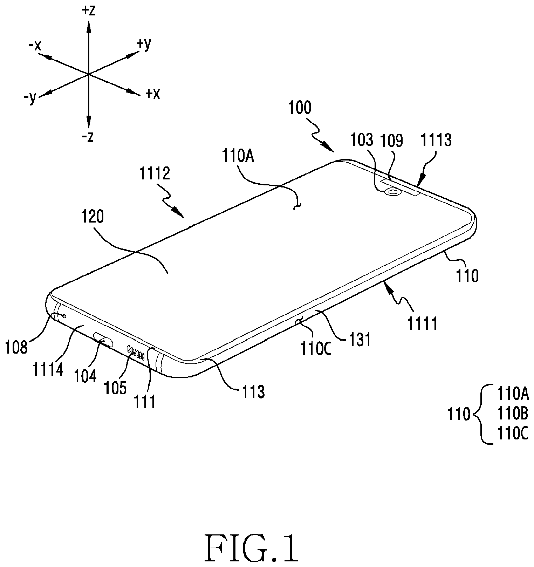

FIG. 1 is a front perspective view of an electronic device 100 according to an embodiment.

Referring to FIG. 1, the electronic device 100 of an embodiment may include a housing 110 including a first surface (or front surface) 110A, a second surface (or rear surface) 110B, and a side surface (or side wall) 110C surrounding a space between the first surface 110A and the second surface 110B. In an embodiment, the housing 110 may refer to a structure forming a portion of the first surface 110A, the second surface 110B, and the side surface 110C. According to an embodiment, the housing 110 may include a front plate 111, a rear plate 112, and a curved portion 113.

According to an embodiment, the first surface 110A may be formed by the front plate 111 (e.g., glass plate including various coating layers, or polymer plate) that is at least partially substantially transparent. In an example, the front plate 111 may include the curved portion 113 that is bent and extended seamlessly from the first surface 110A toward the side surface 110C at least at one side edge portion.

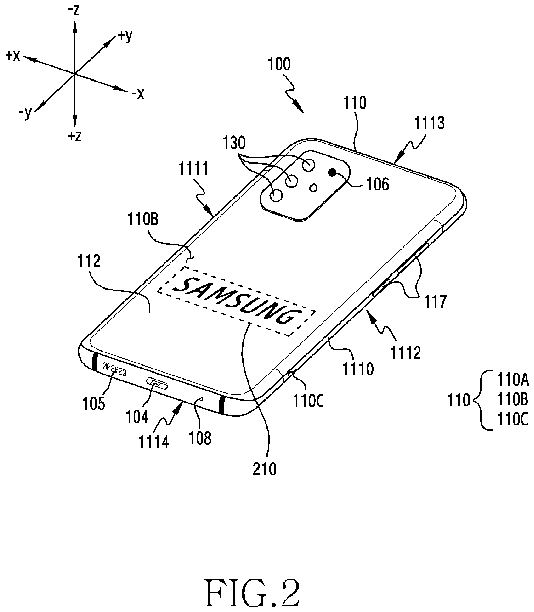

In an embodiment, the side surface 110C may be coupled with the front plate 111 and the rear plate 112, and be formed by a side member (or side bezel structure or side wall) including a metal and/or polymer. In an example, the side surface 110C may include a first side surface 1111 positioned at the right side (e.g., +x direction of FIG. 2) of the electronic device 100 and extending along a first direction (e.g., +y direction of FIG. 2), a second side surface 1112 parallel to the first side surface 1111 and extending along the first direction, a third side surface 1113 extending along a second direction (e.g., +x direction of FIG. 1) perpendicular to the first direction and connecting one end (e.g., one end in the +y direction of FIG. 1) of the first side surface 1111 to one end (e.g., one end in the +y direction of FIG. 1) of the second side surface 1112, and/or a fourth side surface 1114 parallel to the third side surface 1113 and connecting the other end (e.g., one end in the -y direction of FIG. 1) of the first side surface 1111 to the other end (e.g., one end in the -y direction of FIG. 1) of the second side surface 1112.

According to an embodiment, the electronic device 100 may include at least one of a display 120, a camera hole 103, a receiver hole 109, a connector hole 104, a microphone hole 108, or a speaker hole 105. In an example, the electronic device 100 may omit at least one component or additionally include other components. For example, the electronic device 100 may further include a sensor module not shown. The electronic device 100 may omit a key input device 117.

In an embodiment, a sensor such as a proximity sensor, an illuminance sensor, an image sensor, or an iris sensor may be integrated into the display 120 within an area presented by the front plate 111, or be arranged adjacent to the display 120.

In an embodiment, the display 120 may be visually exposed through a significant portion of the front plate 111. In an example, the display 120 may be coupled with or arranged adjacent to a touch detection circuit, a pressure sensor capable of measuring the intensity (pressure) of a touch, and/or a digitizer detecting a magnetic field-type stylus pen. In an example, the edge of the display 120 may be formed substantially identically to an adjacent outer shape (e.g., curved surface) of the front plate 111.

In an embodiment, the connector hole 104 may accommodate a connector for transmitting and receiving power and/or data with an external electronic device (e.g., electronic device 100 of FIG. 1), and/or a connector for transmitting and receiving audio signals with the external electronic device. For example, the connector hole 104 may include a USB connector or an earphone jack (not shown) (or "earphone interface"). In an embodiment, the USB connector and the earphone jack may be implemented as one hole, and in another embodiment, the electronic device 100 may transmit and receive power and/or data, or transmit and receive audio signals, with an external device without a separate connector hole as well.

A microphone for acquiring an external sound may be arranged inside the microphone hole 108, and a plurality of microphones may be arranged therein and detect the direction of the sound. In addition, a speaker may be arranged inside the speaker hole 105 and radiate a sound to the outside. In another embodiment, the speaker hole 105 and the microphone hole 108 may be implemented as one hole, or a speaker (e.g., piezo speaker) may be included without the speaker hole. The speaker hole may include an external speaker hole and a receiver hole for call.

FIG. 2 is a rear perspective view of an electronic device 100 according to an embodiment.

In an embodiment, a second surface 110B may be formed by a substantially opaque rear plate 112. In an example, a rear plate 112 may be formed by, for example, coated or colored glass, ceramic, polymer, metal (e.g., aluminum, stainless steel (STS), or magnesium), or a combination of at least two of the above-described materials. In an example, the rear plate 112 may include a curved portion that is bent and extended seamlessly from the second surface 110B toward a front plate 111 at least at one side edge portion.

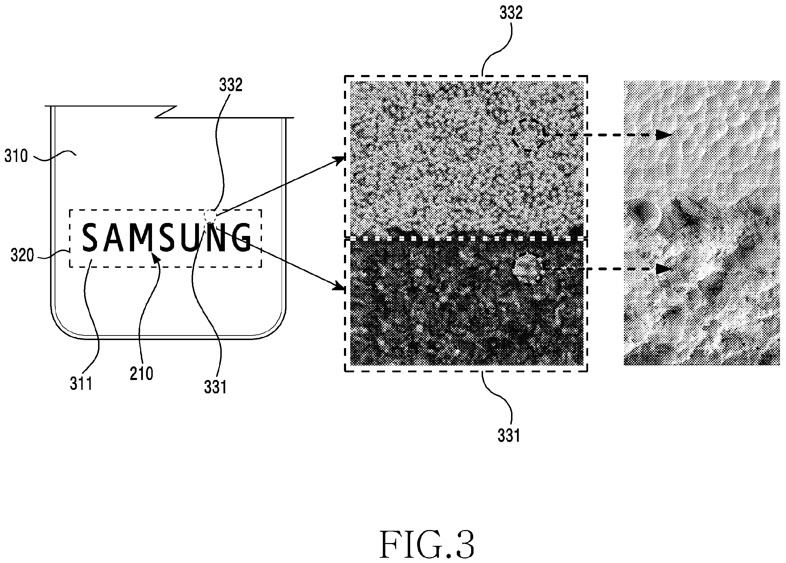

In an embodiment, the rear plate 112 may be formed of a glass layer (e.g., glass layer 310 of FIG. 3). In an embodiment, the glass layer 310 may be formed on the rear plate 112.

According to an embodiment, at least one pattern 210 may be carved by a nano-second laser beam 400 on the rear plate 112 formed of the glass layer 310. According to an embodiment, the nano-second laser beam 400 may be irradiated onto the surface of the glass layer 310 formed on the rear plate 112, thereby carving the at least one pattern 210 on the glass layer 310. For example, the nano-second laser beam 400 may be irradiated to the concave-convex layer 320 formed on the surface of the glass layer 310, thereby carving the at least one pattern 210.

In an embodiment, a key input device 117 may be arranged in a side surface 110C of a housing 110. In an embodiment, the electronic device 100 may not include some or all of the above-mentioned key input devices 217, and the key input device 217 not included may be implemented in other forms, such as soft keys, on a display 120. In an example, the key input device 217 may include at least a portion of a fingerprint sensor disposed on the second surface 110B of the housing 110.

According to an embodiment, the electronic device 100 may include a first optical sensor (e.g., sensor module and/or camera module) 130 and a second optical sensor 106.

In an embodiment, the first optical sensor 130 and the second optical sensor 106 may be disposed on the second surface 110B of the electronic device 100. The first optical sensor 130 may include a plurality of cameras. In an example, the second optical sensor 106 may include a flash. In an example, the first optical sensor 130 and the second optical sensor 106 may include one or more lenses, an image sensor, and/or an image processor. The second optical sensor 106 may include a light emitting diode or a xenon lamp. In an example, two or more lenses (e.g., infrared camera, wide-angle and telephoto lenses) and image sensors may be disposed on one surface of the electronic device 100.

In an embodiment, the electronic device 100 may include a sensor module not shown, and provide an electrical signal or data value corresponding to an internal operating state or an external environmental state. The electronic device 100 may further include a sensor module not shown, for example, at least one of a gesture sensor, a gyro sensor, an air pressure sensor, a magnetic sensor, an acceleration sensor, a grip sensor, a color sensor, an infrared (IR) sensor, a temperature sensor, or a humidity sensor.

FIG. 3 illustrates at least one pattern formed on a rear surface of an electronic device according to an embodiment.

According to an embodiment, FIG. 3 illustrates at least one pattern 210 formed on a second surface 110B of an electronic device 100.

According to an embodiment, the electronic device 100 may include a glass layer 310 and a concave-convex layer 320.

According to an embodiment, the glass layer 310 may be formed on a rear surface or second surface 110B of the electronic device 100. For example, the glass layer 310 may be formed on a rear plate 112 of a housing 110.

According to an embodiment, the concave-convex layer 320 may be formed on the glass layer 310. For example, the concave-convex layer 320 may be formed on the surface of the glass layer 310 that is exposed to the outside.

Referring to FIG. 3 of an embodiment, the concave-convex layer 320 may be formed on a partial area of the glass layer 310. For example, the concave-convex layer 320 may be formed in an area 311 of the glass layer 310 adjacent to an area where the at least one pattern 210 is formed, but is not limited thereto. For example, the concave-convex layer 320 may be formed entirely on the glass layer 310.

According to an embodiment, a laser beam may be radiated to a portion of the concave-convex layer 320, thereby carving the at least one pattern 210 on a rear surface of the electronic device 100. The concave-convex layer 320 may include a plurality of grooves 420. For example, the laser beam may be radiated to the plurality of grooves 420 of the concave-convex layer 320, thereby forming the at least one pattern 210 on the rear surface of the electronic device 100.

For example, a nano-second laser beam may be radiated to partial groovesamong the plurality of grooves 420 of the concave-convex layer 320, thereby cutting inner walls of the partial grooves 430. As the inner walls of the partial grooves 430 are cut, the at least one pattern 210 may be carved on the rear surface of the electronic device 100.

According to an embodiment, the concave-convex layer 320 may include a first area 331 in which the at least one pattern 210 is carved, and a second area 332 in which the at least one pattern 210 is not carved. For example, the first area 331 may include an area which is processed by a laser beam and thus the at least one pattern 210 is engraved. For example, the second area 332 may include an area which is not processed by the laser beam.

Referring to FIG. 3 of an embodiment, the first area 331 may include an area which is processed by the laser beam, thereby being dug deeper than the second area 332. For example, the first area 331 may include an area which is cut by the laser beam, whereby the at least one pattern 210 is formed therein.

Referring to FIG. 3 of an embodiment, the at least one pattern 210 formed on the concave-convex layer 320 may be formed as a character-shaped pattern, but is not limited thereto. For example, an animal-shaped pattern and/or a fruit-shaped pattern may be formed on the glass layer 310.

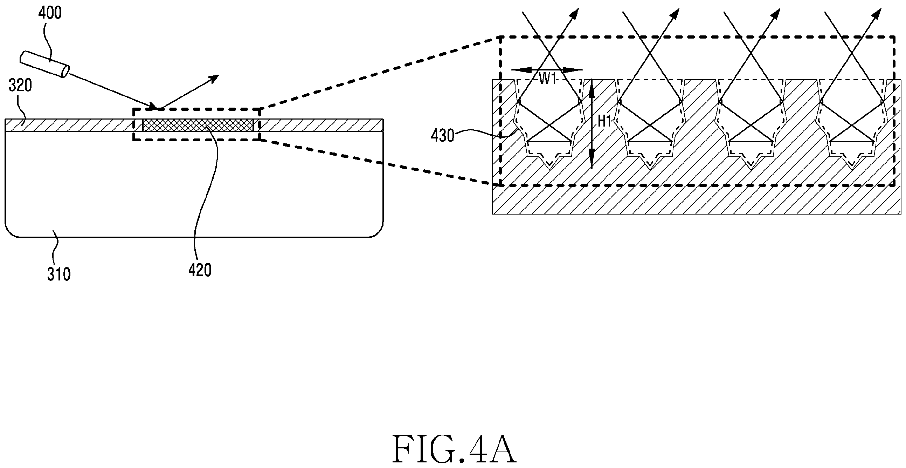

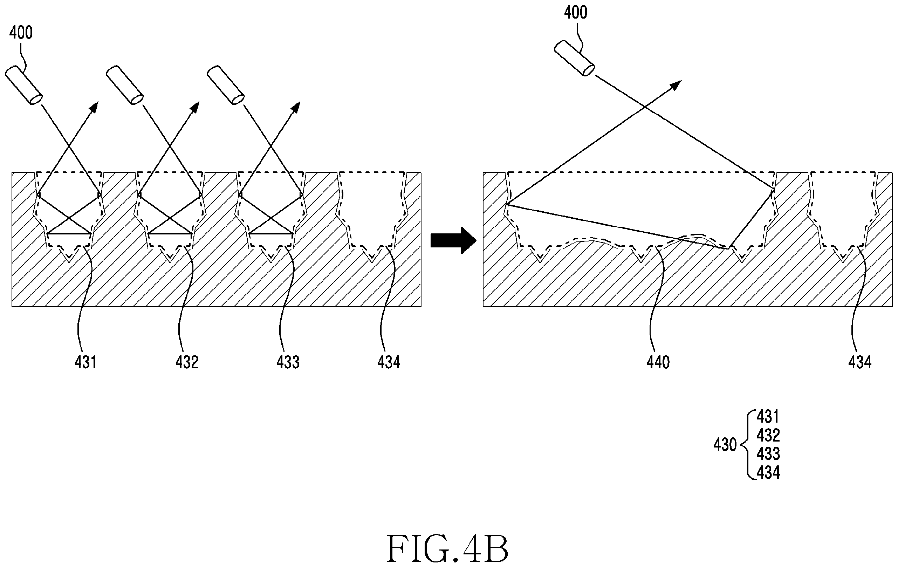

According to an embodiment, an embodiment regarding the at least one pattern 210 formed by cutting the inner walls of the partial grooves 430 will be described later in detail in FIG. 4A and FIG. 4B.

FIG. 4A illustrates a plurality of grooves of a concave-convex layer according to an embodiment.

According to an embodiment, an electronic device 100 may include a glass layer 310 and a concave-convex layer 320.

According to an embodiment, the glass layer 310 may be formed on a second surface 110B of the electronic device 100. According to an embodiment, the glass layer 310 of FIG. 4A may refer to the glass layer 310 of FIGS. 2 and 3.

According to an embodiment, the concave-convex layer 320 may be formed on the glass layer 310. For example, the concave-convex layer 320 may be formed on one surface of the glass layer 310 that is visually exposed to the outside.

According to an embodiment, the concave-convex layer 320 may refer to the concave-convex layer 320 of FIG. 3.

According to an embodiment, the concave-convex layer 320 may include a layer including an irregular surface. For example, the surface of the concave-convex layer 320 may be irregularly formed by a plurality of grooves 420. For example, one surface of the concave-convex layer 320 may face the glass layer 310. For example, the other surface of the concave-convex layer 320 may be exposed to the outside and be irregularly formed by the plurality of grooves 420.

According to an embodiment, the concave-convex layer 320 may include the plurality of grooves 420.

According to an embodiment, the plurality of grooves 420 may be formed in one surface of the concave-convex layer 320. For example, the plurality of grooves 420 may be formed entirely in the surface of the concave-convex layer 320, but is not limited thereto. For example, a partial surface of the concave-convex layer 320 may be formed to have the plurality of grooves 420 and the other partial surface may be formed in a flat shape in which the plurality of grooves 420 are not formed.

According to an embodiment, referring to FIG. 4A, the plurality of grooves 420 are illustrated as four grooves, but the number of the plurality of grooves 420 is not limited thereto. The plurality of grooves 420 may be formed entirely in the surface of the concave-convex layer 320.

Referring to FIG. 4A of an embodiment, the plurality of grooves 420 may be formed as grooves having a predefined width and a predefined height. For example, the plurality of grooves 420 may include an area which is dug at a predefined width and a predefined height. For example, the plurality of grooves 420 may include an internal space which is recessed toward the glass layer 310 at a first width W1 and a first height H1.

According to an embodiment, the first width W1 and the first height H1 of the plurality of grooves 420 may be formed as a length corresponding to the length of a wavelength of a nano-second laser beam 400. For example, the length corresponding to the length of the wavelength of the nano-second laser beam 400 may include a length substantially the same as the wavelength or a length greater than the wavelength.

According to an embodiment, the first width W1 and the first height H1 of the plurality of grooves 420 may have a length greater than the wavelength of the nano-second laser beam 400. According to an embodiment, the first width W1 and the first height H1 of the plurality of grooves 420 may be formed as a length substantially the same as the wavelength of the nano-second laser beam 400.

According to an embodiment, the wavelength of the nano-second laser beam 400 may include a range of 350 nano meter (nm) to 1 millimeter (mm), but is not limited thereto. In another example, the wavelength of the nano-second laser beam 400 may include a range of 350 nm to 10.60 micro meter (µm).

According to an embodiment, the first width W1 may include a length of 350 nm or more, but is not limited thereto. For example, the first width W1 may include a range of 350 nm to 1 mm. In another example, the first width W1 may include a range of 350 nm to 10.60 µm.

According to an embodiment, the first height H1 may include a length of 350 nm or more, but is not limited thereto. For example, the first height H1 may include a range of 350 nm to 1 mm. For example, unlike the first width W1, the first height H1 may not be limited in height. As another example, the first height H1 may include a range of 350 nm to 10.60 µm.

According to an embodiment, as the plurality of grooves 420 are formed at a length corresponding to the length of the wavelength of the nano-second laser beam 400, the nano-second laser beam 400 may be multi-reflected and multi-absorbed on the inner walls of the plurality of grooves 420 having a length greater than the wavelength.

According to an embodiment, partial grooves 430 among the plurality of grooves 420 may be processed by a laser beam.

According to an embodiment, the partial grooves 430 may be processed, whereby the at least one pattern 210 may be carved on the concave-convex layer 320. For example, the partial grooves 430 may be cut by the nano-second laser beam 400. For example, the nano-second laser beam 400 may be radiated toward the inner space of the partial grooves 430 among the plurality of grooves 420. For example, the nano-second laser beam 400 may be radiated toward the inner space of the partial grooves 430, thereby cutting the inner walls of the partial grooves 430. For example, the nano-second laser beam 400 may be radiated toward the inner space of the partial grooves 430, and be multi-absorbed and multi-reflected on the inner walls of the partial grooves 430.

According to an embodiment, the nano-second laser beam 400 may be multi-absorbed and multi-reflected on the inner walls, whereby the inner walls of the partial grooves 430 may be cut, and the at least one pattern 210 may be formed on the concave-convex layer 320.

According to an embodiment, that the nano-second laser beam 400 is multi-reflected may include that the nano-second laser beam 400 is reflected multiple times from the inner walls of the partial grooves 430. For example, the nano-second laser beam 400 may be reflected multiple times from the inner walls of the partial grooves 430.

According to an embodiment, that the nano-second laser beam 400 is multi-absorbed may include that the nano-second laser beam 400 is absorbed multiple times from the inner walls of the partial grooves 430. In a process in which the nano-second laser beam 400 is reflected multiple times from the inner walls of the partial grooves 430, a portion of the nano-second laser beam 400 may be absorbed multiple times by the inner walls of the partial grooves 430. As a portion of the nano-second laser beam 400 is absorbed multiple times by the inner walls of the partial grooves 430, a portion of the inner walls of the partial grooves 430 may be cut. For example, the nano-second laser beam 400 may be absorbed by the inner walls of the partial grooves 430, and the inner walls of the partial grooves 430 may be cut.

According to an embodiment, FIG. 4A illustrates that the nano-second laser beam 400 is reflected and absorbed four times on the inner walls of the partial grooves 430, but the number of reflections is not limited thereto. For example, the nano-second laser beam 400 may be reflected and absorbed more than five times on the inner walls of the partial grooves 430.

According to an embodiment, the nano-second laser beam 400 may be multi-absorbed and multi-reflected on the inner walls of the partial grooves 430, whereby the inner wall of each of the partial grooves 430 may be cut and the boundaries between the partial grooves 430 may collapse. For example, the inner wall between the respective partial grooves 430 may be cut, whereby the partial grooves 430 may be combined into one groove (e.g., one groove 440 of FIG. 4B). An embodiment regarding that the partial grooves 430 are formed as one groove 440 by cutting will be described later in detail with reference to FIG. 4B.

According to an embodiment, as the plurality of grooves 420 are formed at the first width W1 and the first height H1, the nano-second laser beam 400 may be multi-absorbed and multi-reflected on the inner walls of the partial grooves 430. For example, as the first width W1 and the first height H1 are formed to be greater than the wavelength of the nano-second laser beam 400, the nano-second laser beam 400 may be reflected and absorbed multiple times on the inner walls of the partial grooves 430.

According to an embodiment, when the at least one pattern 210 is carved by the nano-second laser beam 400, the at least one pattern 210 may be carved more clearly on the concave-convex layer 320 in which the plurality of grooves 420 are formed than on a layer in which the plurality of grooves are not formed. For example, as the nano-second laser beam 400 may be multi-absorbed and multi-reflected in the concave-convex layer 320, the at least one pattern 210 may be carved more clearly on the concave-convex layer 320 in which the plurality of grooves 420 are formed than on the layer in which the plurality of grooves are not formed.

According to an embodiment, owing to the concave-convex layer 320 including the plurality of grooves 420, the at least one pattern 210 with improved sharpness may be formed, even when the nano-second laser beam 400 rather than a picosecond or femtosecond laser beam is used.

According to an embodiment, as the nano-second laser beam 400 may be multi-absorbed and multi-reflected in the concave-convex layer 320, the process of carving the at least one pattern 210 may have a reduced process time compared to the process of carving on the layer where the plurality of grooves are not formed.

According to an embodiment, owing to the concave-convex layer 320 including the plurality of grooves 420, a process time of forming the at least one pattern 210 may be reduced, even when the nano-second laser beam 400 rather than the picosecond or femtosecond laser beam is used.

According to an embodiment, as the nano-second laser beam 400 is used, auxiliary materials and consumables may be unnecessary. According to an embodiment, as the auxiliary materials or consumables are unnecessary, the at least one pattern 210 may be formed in an environmentally friendly method.

FIG. 4B illustrates a plurality of grooves of a concave-convex layer according to an embodiment.

Referring to FIG. 4B, the nano-second laser beam 400 may be radiated to the partial grooves 430 among the plurality of grooves 420. For example, the nano-second laser beam 400 may be radiated to the inner space of the partial grooves 430 among the plurality of grooves 420, thereby being multi-absorbed and multi-reflected on the inner walls of the partial grooves 430. For example, the nano-second laser beam 400 may be multi-absorbed and multi-reflected on the inner walls of the partial grooves 430, thereby forming the at least one pattern 210 on the concave-convex layer 320.

According to an embodiment, the partial grooves 430 may include a first groove 431, a second groove 432, a third groove 433, and a fourth groove 434. According to an embodiment, the first groove 431, the second groove 432, the third groove 433, and the fourth groove 434 may refer to the plurality of grooves 420 of FIG. 4A. For example, the first groove 431, the second groove 432, the third groove 433, and the fourth groove 434 may have a first width W1 and a first height H1, but are not limited thereto. For example, the first groove 431, the second groove 432, the third groove 433, and the fourth groove 434 may have different widths and different heights.

Referring to FIG. 4B, it is illustrated that the first groove 431, the second groove 432, the third groove 433, and the fourth groove 434 are formed to be substantially identical to each other, but are not limited thereto. For example, as the first groove 431, the second groove 432, the third groove 433, and the fourth groove 434 are formed in different shapes, the surface of the concave-convex layer 320 may be formed irregularly.

According to an embodiment, as the nano-second laser beam 400 is radiated to the first groove 431, the second groove 432 and the third groove 433, the first groove 431, the second groove 432 and the third groove 433 may be formed as one groove 440. For example, a wall between the first groove 431 and the second groove 432 may be cut by the nano-second laser beam 400. For example, a wall between the second groove 432 and the third groove 433 may be cut by the nano-second laser beam 400.

According to an embodiment, the walls between the first groove 431, the second groove 432 and the third groove 433 may be cut by the nano-second laser beam 400, whereby the first groove 431, the second groove 432, and the third groove 433 may be formed as one groove 440.

According to an embodiment, as the first groove 431, the second groove 432, and the third groove 433 are formed as one groove 440, at least one pattern (e.g., at least one pattern 210 of FIG. 3) may be formed on the concave-convex layer 320. For example, the at least one pattern 210 may be formed on the concave-convex layer 320 through a process in which the partial grooves 430 among the plurality of grooves 420 are formed as one groove 440.

According to an embodiment, according to the process of multi-absorption and multi-reflection of the nano-second laser beam 400 on the concave-convex layer 320, the at least one pattern 210 may be more clearly carved on the concave-convex layer 320 in which the plurality of grooves 420 are formed than on a layer in which the plurality of grooves are not formed.

According to an embodiment, as the nano-second laser beam 400 may be multi-absorbed and multi-reflected on the concave-convex layer 320, the process of carving the at least one pattern 210 may have a reduced process time than the process of carving on the layer in which the plurality of grooves are not formed.

According to an embodiment, as the nano-second laser beam 400 is used, auxiliary materials and consumables may be unnecessary. According to an embodiment, as the auxiliary materials and the consumables are unnecessary, the at least one pattern 210 may be formed in an environmentally friendly method.

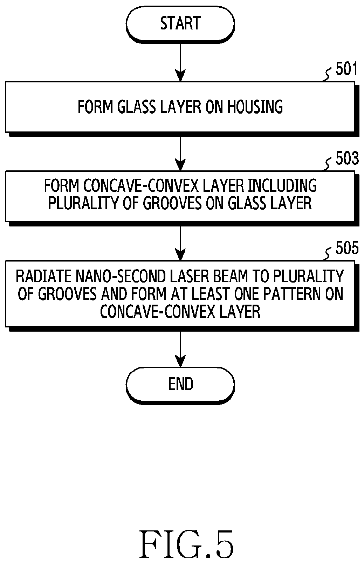

FIG. 5 is a flowchart illustrating the process of forming at least one pattern according to an embodiment.

According to an embodiment, FIG. 5 is a flowchart illustrating a method of forming at least one pattern of FIG. 3 (e.g., at least one pattern 210 of FIG. 3) on a housing 110 of an electronic device 100.

According to an embodiment, process 501 may include the operation of preparing a glass layer 310 formed on the housing 110. For example, process 501 may include the operation of laminating the glass layer 310 on the housing 110. For example, process 501 may include the process of forming the glass layer 310 together in the process of forming the housing 110.

According to an embodiment, after the at least one pattern 210 is carved on the glass layer 310 through processes 503 and 505 described below, the glass layer 310 on which the at least one pattern 210 is carved may be laminated on the housing 110.

According to an embodiment, the at least one pattern 210 may be carved on the glass layer 310 laminated on the housing 110 through processes 503 and 505 to be described later.

According to an embodiment, process 503 may include the operation of forming a concave-convex layer 320 including a plurality of grooves 420 on the glass layer 310.

According to an embodiment, process 503 of forming the concave-convex layer 320 may include the process of forming the plurality of grooves 420 on the concave-convex layer 320 through a chemical etching process, a blasting process, or a dry etching process. For example, the plurality of grooves 420 may be formed on the concave-convex layer 320 through the process of corrosion by a chemical reaction of hydrofluoric acid, sulfuric acid, nitric acid, and/or ammonium bifluoride with a glass substrate (SiO₂). For example, the plurality of grooves 420 may be formed on the concave-convex layer 320 through the blasting process that uses fine particles. For example, the plurality of grooves 420 may be formed on the concave-convex layer 320 through the dry etching process that uses plasma, but is not limited thereto. For example, the plurality of grooves 420 may be formed on the concave-convex layer 320 through a wet etching process.

According to an embodiment, the concave-convex layer 320 may refer to the concave-convex layer 320 of FIG. 3. For example, the concave-convex layer 320 may be formed entirely on the surface of the glass layer 310. For example, the concave-convex layer 320 may be formed on a partial surface of the glass layer 310.

According to an embodiment, process 505 may include the operation of radiating the nano-second laser beam 400 to the plurality of grooves 420 and forming the at least one pattern 210 on the concave-convex layer 320.

According to an embodiment, the nano-second laser beam 400 may be radiated to partial grooves 430 among the plurality of grooves 420, thereby forming the at least one pattern 210. For example, the nano-second laser beam 400 may be multi-reflected and multi-absorbed on the respective inner walls of the partial grooves 430, thereby forming the at least one pattern 210.

According to an embodiment, an embodiment regarding that the nano-second laser beam 400 is multi-reflected and multi-absorbed on the respective inner walls of the partial grooves 430 may refer to FIGS. 4A and 4B. For example, according to an embodiment, as the plurality of grooves 420 are formed at a first width W1 and a first height H1, the nano-second laser beam 400 may be multi-absorbed and multi-reflected on the inner walls of the partial grooves 430. For example, as the first width W1 and the first height H1 are formed greater than the wavelength of the nano-second laser beam 400, the nano-second laser beam 400 may be reflected and absorbed multiple times on the inner walls of the partial grooves 430.

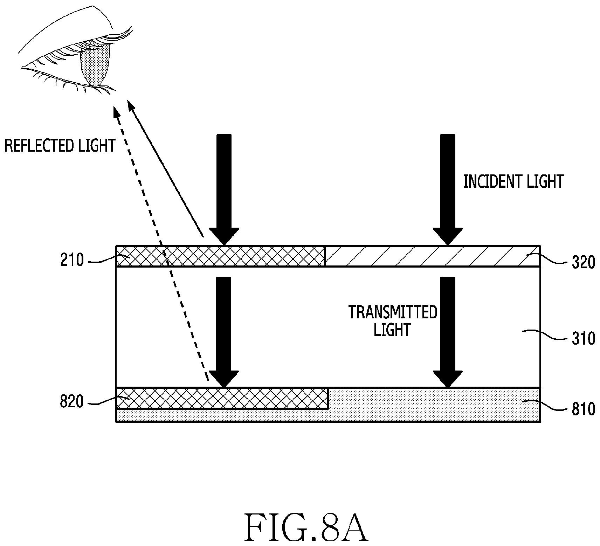

According to an embodiment, a method of forming the at least one pattern 210 may further include the process of laminating a color layer (e.g., color layer 810 of FIG. 8A) arranged between the housing 110 and the glass layer 310, before process 501 of forming the glass layer 310. According to an embodiment, an embodiment regarding the process of laminating the color layer 810 will be described later in detail with reference to FIG. 8A.

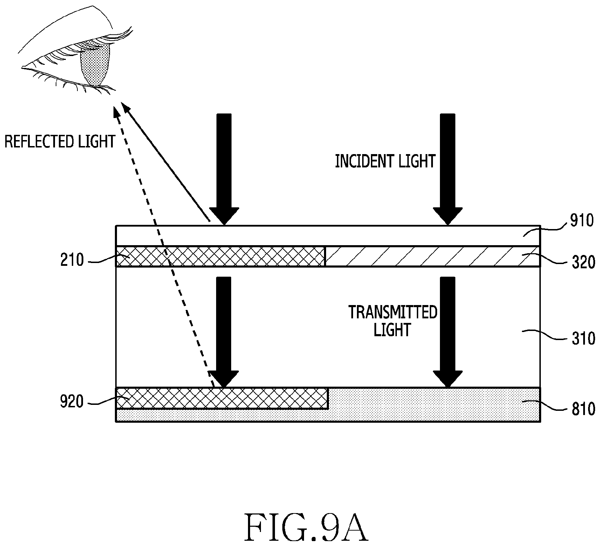

According to an embodiment, the method of forming the at least one pattern 210 may include the process of further laminating a second light transmitting layer having a lower light transmittance than the glass layer 310 on the concave-convex layer 320, after process 505 of forming the at least one pattern 210. According to an embodiment, an embodiment regarding the process of further laminating a first light transmitting layer having a lower light transmittance than the glass layer 310 will be described later in detail in FIG. 9A.

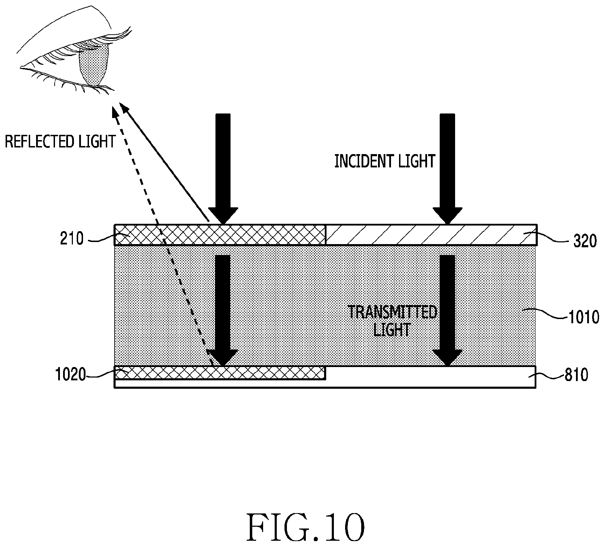

According to an embodiment, the method of forming the at least one pattern 210 may include the process of replacing a transparent glass layer 310 with an opaque or translucent glass layer, in process 501 of forming the glass layer 310. An embodiment regarding the opaque or translucent glass layer will be described later in detail in FIG. 10.

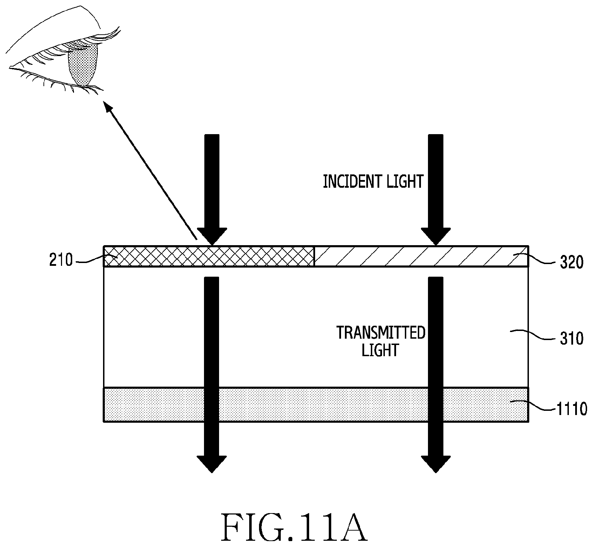

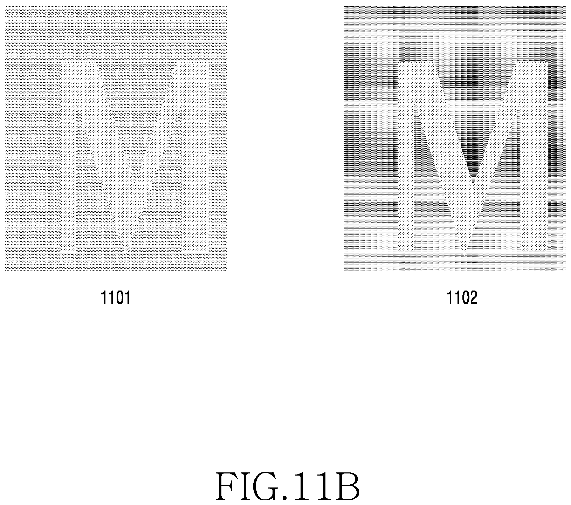

According to an embodiment, the method of forming the at least one pattern 210 may further include the process of laminating a second light transmitting layer arranged between the housing 110 and the glass layer 310, before process 501 of forming the glass layer 310. The second light transmitting layer may have substantially the same or higher light transmittance than the glass layer 310. According to an embodiment, an embodiment regarding the process of laminating the second light transmitting layer will be described later in detail in FIG. 11.

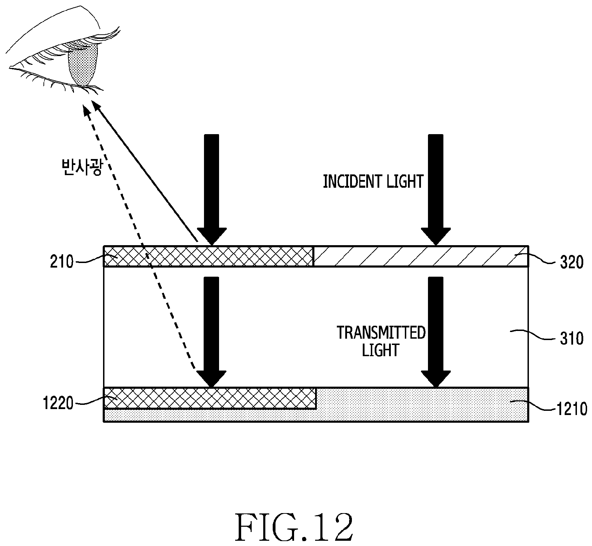

According to an embodiment, the method of forming the at least one pattern 210 may further include the process of laminating a light absorbing layer 1210 arranged between the housing 110 and the glass layer 310 and having a lower reflectance than the glass layer, before process 501 of forming the glass layer 310. According to an embodiment, an embodiment regarding the process of laminating the light absorbing layer 1210 having the lower reflectance than the glass layer will be described later in detail in FIG. 12.

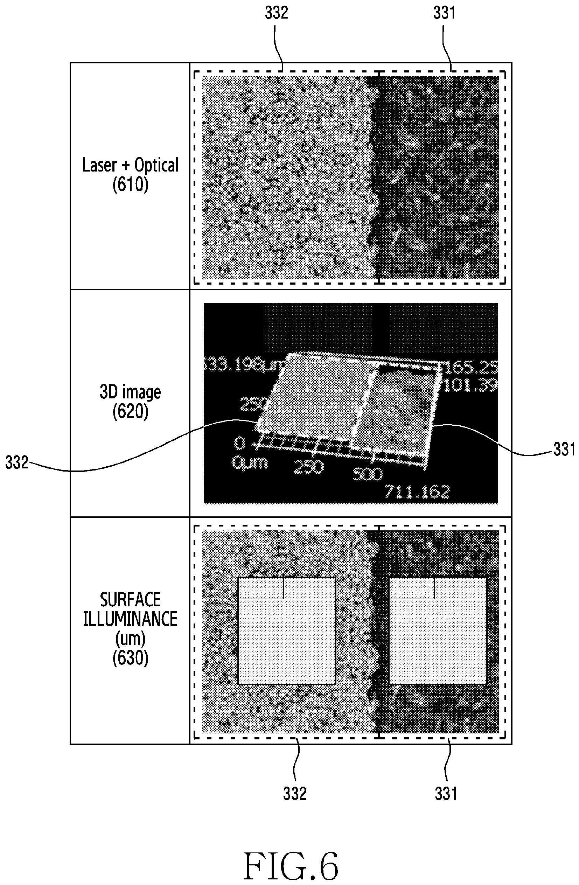

FIG. 6 illustrates a concave-convex layer according to an embodiment.

According to an embodiment, FIG. 6 illustrates a cross-section of a concave-convex layer 320.

According to an embodiment, FIG. 6 illustrates a boundary between an area where a nano-second laser beam (e.g., nano-second laser beam 400 of FIGS. 4A and 4B) on the concave-convex layer 320 is radiated and an area where the nano-second laser beam 400 is not radiated.

According to an embodiment, FIG. 6 illustrates the distinguishment of an area where at least one pattern (e.g., at least one pattern 210 of FIG. 3) on the concave-convex layer 320 is formed and an area where the at least one pattern is not formed.

According to an embodiment, the concave-convex layer 320 may include a first area 331 where the nano-second laser beam 400 is radiated and the at least one pattern 210 is carved, and a second area 332 where the at least one pattern 210 is not carved.

According to an embodiment, figure 610 illustrates a boundary between the first area 331 and the second area 332. According to an embodiment, the first area 331 and the second area 332 may refer to the first area 331 and the second area 332 of FIG. 3.

According to an embodiment, figure 620 illustrates a 3D image of the first area 331 and the second area 332. According to an embodiment, figure 620 may illustrate a height difference between the first area 331 and the second area 332 on the 3D image.

Referring to figure 620 of an embodiment, the second area 332 of the concave-convex layer 320 may be formed to have a greater height than the first area 331. For example, as the first area 331 is cut by the nano-second laser beam 400, the first area 331 may be formed to have a less height than the second area 332. For example, according to an embodiment, as the first area 331 is cut by the nano-second laser beam 400, the first area 331 may be formed to have a less thickness than the second area 332 on the glass layer 310.

According to an embodiment, figure 630 is a diagram comparing surface illuminance values of the first area 331 and the second area 332 with each other. For example, figure 630 is a diagram comparing the brightness of the first area 331 and the second area 332 of the concave-convex layer 320 with each other.

The surface illuminance value may include an average brightness value of a corresponding area measured by an illuminance sensor. For example, the brightness of an area having a high surface illuminance value may be greater than that of an area having a low surface illuminance value. For example, the area having the high surface illuminance value may be more visible to a user than the area having the low surface illuminance value.

According to an embodiment, the illuminance value of the first area 331 may be higher than the illuminance value of the second area 332. For example, the illuminance value of the first area 331 may be 6.307 µm, and the illuminance value of the second area 332 may be 0.872 µm, but the illuminance value of the first area 331 and the illuminance value of the second area 332 are not limited thereto.

According to an embodiment, owing to a brightness difference between the first area 331 and the second area 332, the at least one pattern 210 may be visible brighter than the surrounding area. For example, as the first area 331 is brighter than the second area 332, the user may easily visually recognize the at least one pattern 210.

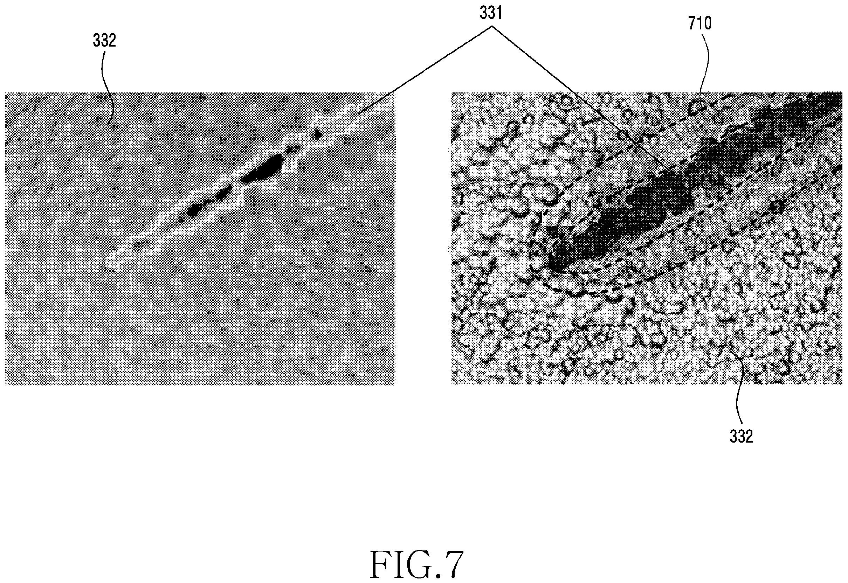

FIG. 7 illustrates a heat affected zone formed on a concave-convex layer according to an embodiment.

According to an embodiment, FIG. 7 illustrates a heat affected zone 710 formed around at least one pattern 210.

According to an embodiment, a concave-convex layer 320 may include a first area 331 in which a nano-second laser beam 400 is radiated and the at least one pattern 210 is carved, and a second area 332 in which the at least one pattern 210 is not carved.

According to an embodiment, the first area 331 and the second area 332 may refer to the first area 331 and the second area 332 of FIGS. 3 and 6.

According to an embodiment, as the at least one pattern 210 is formed on the concave-convex layer 320 by the nano-second laser beam 400, the heat affected zone 710 may be formed around the at least one pattern 210. For example, partial grooves 430 among a plurality of grooves 420 of the concave-convex layer 320 may be cut by the nano-second laser beam 400, whereby the heat affected zone 710 may be formed around the partial grooves 430. For example, the heat affected zone 710 may be formed around the first area 331 by the nano-second laser beam 400.

According to an embodiment, in the process of processing the partial grooves 430 by the nano-second laser beam 400, heat affecting may occur around the partial grooves 430, whereby the heat affected zone 710 may be formed around the partial grooves 430.

According to an embodiment, the heat affected zone 710 within the second area 332 may be visible substantially identically to an area other than the heat affected zone 710 within the second area 332. For example, the partial grooves affected by heat among the plurality of grooves 420 may be visible substantially identically to some other grooves not affected by heat. For example, the partial grooves corresponding to the heat affected zone 710 may not be distinguished by naked eyes from the some other grooves within the second area 332.

According to an embodiment, as the partial grooves corresponding to the heat affected zone 710 are not distinguished by naked eyes from the some other grooves within the second area 332, a user of an electronic device 100 may not be able to recognize the heat affected zone 710 by naked eyes, and may only recognize the at least one pattern 210 of the first area 331.

According to an embodiment, even though the heat affected zone 710 is formed by the nano-second laser beam 400 around the at least one pattern 210, the user may distinguish the concave-convex layer 320 into the first area 331 in which the at least one pattern 210 is carved and the second area 332 in which the at least one pattern 210 is not carved.

FIG. 8A illustrates a laminated structure of a glass layer and a concave-convex layer according to an embodiment.

According to an embodiment, an electronic device 100 may include a glass layer 310, and a concave-convex layer 320 laminated on the glass layer 310 and having at least one pattern 210 carved thereon.

According to an embodiment, the glass layer 310 may be formed of transparent glass. According to an embodiment, as the glass layer 310 is formed of transparent glass, a user may recognize a housing 110 of the electronic device 100 through the glass layer 310.

According to an embodiment, the electronic device 100 may further include a color layer 810 arranged between the housing 110 and the glass layer 310.

According to an embodiment, the color layer 810 may include at least one color. According to an embodiment, as the color layer 810 is further formed, the user of the electronic device 100 may visually recognize the housing 110 including the at least one color through the transparent glass layer 310.

According to an embodiment, when the at least one pattern 210 is formed on the concave-convex layer 320, an afterimage of the at least one pattern 210 may be formed on the color layer 810. For example, when light is incident on the concave-convex layer 320, light transmission and light diffusion may occur due to the irregular surface of the concave-convex layer 320 in which a plurality of grooves 420 are formed, and an afterimage 820 of the at least one pattern 210 may be formed on the color layer 810.

According to an embodiment, FIG. 8A illustrates that the color layer 810 is formed beneath the glass layer 310, but is not limited thereto. For example, the color layer 810 may be formed on the concave-convex layer 320 on which the at least one pattern 210 is formed.

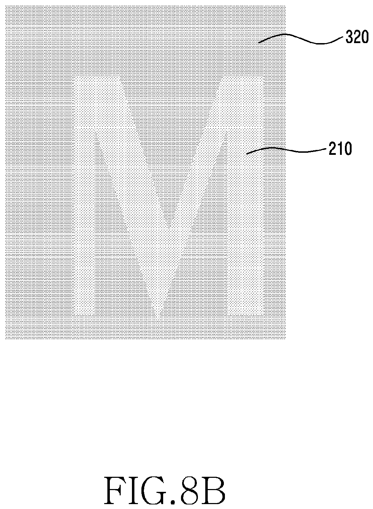

FIG. 8B illustrates at least one pattern formed on a concave-convex layer according to an embodiment.

Referring to FIG. 8B, the at least one pattern 210 may be formed on the concave-convex layer 320. For example, the at least one pattern 210 in the shape of the letter M may be formed on the concave-convex layer 320, but is not limited thereto. For example, the at least one pattern 210 in the form of a letter or picture may be formed on the concave-convex layer 320.

FIG. 9A illustrates a laminated structure of a glass layer and a concave-convex layer according to an embodiment.

According to an embodiment, unlike FIG. 8A, an electronic device 100 of FIG. 9A may further include a first light transmitting layer 910 disposed on a concave-convex layer 320.

According to an embodiment, the first light transmitting layer 910 may be disposed on the concave-convex layer 320 on which at least one pattern 210 is carved.

According to an embodiment, the first light transmitting layer 910 may have a lower light transmittance than the glass layer 310.

According to an embodiment, only a portion of light incident through the first light transmitting layer 910 may reach a color layer 810 through the glass layer 310. For example, the light incident through the first light transmitting layer 910 may pass through the first light transmitting layer 910. As the amount of transmitted light decreases while the light passes through the first light transmitting layer 910, the amount of transmitted light reaching the concave-convex layer 320 and the amount of diffused light diffused on the concave-convex layer 320 may decrease.

According to an embodiment, as the first light transmitting layer 910 is further formed, the at least one pattern 210 of FIG. 9A may be more clearly recognized than the at least one pattern 210 of FIGS. 8A and 8B. For example, as the first light transmitting layer 910 having the lower light transmittance is formed, an afterimage 920 of the at least one pattern 210 recognized by a user may be less clear than the afterimage of the at least one pattern 210 of FIGS. 8A and 8B.

According to an embodiment, as the afterimage of the pattern is reduced, the user of the electronic device 100 may recognize the at least one pattern 210 of FIG. 9A more clearly in time than the at least one pattern 210 of FIGS. 8A and 8B.

According to an embodiment, the first light transmitting layer 910 may be implemented on the concave-convex layer 320 through deposition, but is not limited thereto. According to an embodiment, the first light transmitting layer 910 may be implemented through a printing method, a painting method, a film attachment method, and/or an OCA method.

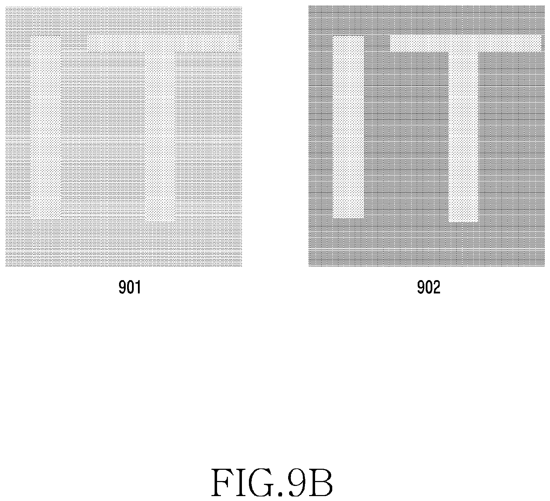

FIG. 9B illustrates at least one pattern according to an embodiment.

According to an embodiment, FIG. 9B may be a diagram comparing at least one pattern of the electronic device in which the first light transmitting layer 910 is not arranged, with at least one pattern of the electronic device in which the first light transmitting layer 910 is arranged.

According to an embodiment, FIG. 9B illustrates case 1 901 in which the first light transmitting layer 910 is not arranged and case 2 902 in which the first light transmitting layer 910 is arranged.

According to an embodiment, case 1 901 may illustrate the at least one pattern 210 of the electronic device 100 in which the first light transmitting layer 910 is not disposed on the concave-convex layer 320. For example, case 1 901 may illustrate the at least one pattern of the electronic device 100 of FIG. 8A.

According to an embodiment, case 2 902 may illustrate the at least one pattern 210 of the electronic device 100 in which the first light transmitting layer 910 is disposed on the concave-convex layer 320. For example, case 2 902 may illustrate the at least one pattern of the electronic device 100 of FIG. 9A.

According to an embodiment, as the first light transmitting layer 910 is further formed, the at least one pattern 210 of case 2 902 may be more clearly recognized than the at least one pattern 210 of case 1 901. For example, as the first light transmitting layer 910 having the lower light transmittance is formed, the sharpness of the afterimage 920 of the at least one pattern 210 recognized by the user may be reduced in comparison to the sharpness of the afterimage of the at least one pattern 210 of FIG. 8A.

According to an embodiment, as the sharpness of the afterimage of the pattern is reduced, the user of the electronic device 100 may visually recognize the at least one pattern 210 of FIG. 9A more clearly than the at least one pattern 210 of FIG. 8A.

FIG. 10 illustrates a laminated structure of a glass layer and a concave-convex layer according to an embodiment.

According to an embodiment, unlike the electronic device 100 including the glass layer 310 formed of transparent glass of FIG. 8A, an electronic device 100 of FIG. 10 may include a glass layer 1010 including a translucent glass or an opaque glass.

According to an embodiment, when the glass layer 310 formed of transparent glass of FIG. 8A and FIG. 9A corresponds to a first glass layer, the glass layer 1010 including the translucent glass or opaque glass of FIG. 10 may correspond to a second glass layer. The glass layer 1010 including the translucent glass or opaque glass may be described below as the second glass layer.

According to an embodiment, the second glass layer 1010 may have a lower light transmittance than the first glass layer 310.

For example, when the first glass layer 310 has a light transmittance of 100 %, the second glass layer 1010 may have a light transmittance in a range of 0 % to 90 %. However, the light transmittance of the second glass layer 1010 is not limited to the range of 0 % to 90 %. For example, the second glass layer 1010 may have a light transmittance in a range of 90 % to 100 %.

According to an embodiment, even if the first light transmitting layer 910 of FIG. 9A is omitted, as the second glass layer 1010 is formed, the at least one pattern 210 may be made clear.

According to an embodiment, even if the first light transmitting layer 910 is omitted, as the second glass layer 1010 having the low light transmittance is formed, the visibility of the at least one pattern 210 may be improved. For example, as the second glass layer 1010 having the low light transmittance is formed, only a portion of light incident through a concave-convex layer 320 may reach a color layer 810 through the second glass layer 1010. For example, as the light passes through the second glass layer 1010, the amount of transmitted light incident through the concave-convex layer 320 may decrease.

According to an embodiment, as the second glass layer 1010 is formed, the at least one pattern 210 of FIG. 10 may be formed more clearly than the at least one pattern 210 of FIG. 8A and FIG. 8B.

According to an embodiment, as the second glass layer 1010 is formed, a light transmittance may decrease, and the sharpness of an afterimage 1020 of the at least one pattern 210 may be less clear than the sharpness of the afterimage of the at least one pattern 210 of FIG. 8A and FIG. 8B. For example, as the light transmittance decreases, the sharpness of the afterimage 1020 of the at least one pattern 210 may decrease, and the amount of reflection of the afterimage 1020 may decrease.

According to an embodiment, as the sharpness of the afterimage 1020 decreases, the visibility of the at least one pattern 210 may be improved.

According to an embodiment, as the afterimage 1020 of the at least one pattern 210 decreases, a user of the electronic device 100 may recognize the at least one pattern 210 of FIG. 10 more clearly in time than the at least one pattern 210 of FIG. 8A and FIG. 8B.

According to an embodiment, as the first light transmitting layer 910 of FIG. 9A is omitted, the laminated structure of the concave-convex layer of FIG. 10 may be structurally simpler than the laminated structure of FIG. 9A. For example, when the second glass layer 1010 is arranged, the sharpness of the at least one pattern 210 carved by a nano-second laser beam 400 may be improved even without the first light transmitting layer 910 of FIG. 9A.

According to an embodiment, even if a laser wavelength absorption rate of the second glass layer 1010 is low, the at least one pattern 210 may be formed because of the concave-convex layer 320 including a plurality of grooves 420. For example, even when the nano-second laser beam 400 is not absorbed by the second glass layer 1010, the nano-second laser beam 400 may be multi-reflected and multi-absorbed on the inner walls of the plurality of grooves 420, thereby forming the at least one pattern 210.

FIG. 11A illustrates a laminated structure of a glass layer and a concave-convex layer according to an embodiment.

According to an embodiment, unlike the electronic device 100 of FIG. 8A, an electronic device 100 of FIG. 11A may omit the color layer 810, and further include a second light transmitting layer 1110 that transmits light.

According to an embodiment, the second light transmitting layer 1110 may be formed between a housing 110 of the electronic device 100 and a glass layer 310.

According to an embodiment, the glass layer 310 may refer to the glass layer 310 of FIGS. 8A to 9A. For example, the glass layer 310 may include transparent glass. For example, the glass layer 310 may include glass including a light transmittance of 99 % to 100 %.

According to an embodiment, the second light transmitting layer 1110 may be formed of glass having substantially the same or higher light transmittance than the glass layer 310. For example, light incident on a concave-convex layer 320 may transmit through the glass layer 310 and the second light transmitting layer 1110. For example, the light incident on the concave-convex layer 320 may pass through the glass layer 310 and transmit through the second light transmitting layer 1110 as it is without being reflected again.

According to an embodiment, the second light transmitting layer 1110 may be formed of a material having substantially the same light transmittance as that of the first glass layer 310 or having a higher light transmittance than that of the first glass layer 310.

For example, it may be implemented as an anti-reflection coating that implements a high transmittance through a low-reflection coating. For example, it may be implemented by an ink process, a painting process, a ultra-violet (UV) coating process, and/or an optically clear adhesive (OCA) having a higher light transmittance than the first glass layer. For example, the second light transmitting layer 1110 may be omitted and an empty space may be formed between the first glass layer 310 and the housing 110.

According to an embodiment, as the color layer 810 is omitted, and the second light transmitting layer 1110 having substantially the same or higher transmittance than the glass layer 310 is disposed, the visibility of the at least one pattern 210 may be improved. For example, as light incident on the concave-convex layer 320 passes through the second light transmitting layer 1110 as it is, an afterimage of the at least one pattern 210 may not be formed on the second light transmitting layer 1110.

According to an embodiment, when the afterimage of the at least one pattern 210 is not formed, the visibility of the at least one pattern 210 may be improved.

FIG. 11B illustrates at least one pattern according to an embodiment.

According to an embodiment, FIG. 11B may be a diagram comparing at least one pattern of an electronic device in which the second light transmitting layer 1110 is not arranged with at least one pattern of an electronic device in which the second light transmitting layer 1110 is arranged.

According to an embodiment, FIG. 11B illustrates case 3 1101 in which the second light transmitting layer 1110 is not formed, and case 4 1102 in which the second light transmitting layer 1110 is formed.

According to an embodiment, case 3 1101 may illustrate at least one pattern 210 of an electronic device 100 in which the second light transmitting layer 1110 is not formed. For example, case 3 1101 may illustrate the at least one pattern of the electronic device 100 of FIG. 8A.

According to an embodiment, case 4 1102 may illustrate the at least one pattern 210 of the electronic device 100 including the second light transmitting layer 1110 formed between the housing 110 and the glass layer 310. For example, case 4 1102 may illustrate the at least one pattern 210 of the electronic device 100 of FIG. 11A.

According to an embodiment, as the second light transmitting layer 1110 is arranged, the visibility of the at least one pattern 210 may be improved. For example, as light incident on the concave-convex layer 320 transmits through the second light transmitting layer 1110 as it is, an afterimage of the at least one pattern 210 may not be formed on the second light transmitting layer 1110.

According to an embodiment, as the afterimage of the at least one pattern 210 is not formed, the visibility of the at least one pattern 210 of case 4 1102 may be improved compared to the visibility of the at least one pattern of case 3 1101.

FIG. 12 illustrates a laminated structure of a glass layer and a concave-convex layer according to an embodiment.

According to an embodiment, unlike the electronic device 100 of FIG. 8A, an electronic device 100 of FIG. 12 may omit the color layer 810, and further include a light absorbing layer 1210 that reflects light.

According to an embodiment, a glass layer 310 may refer to the glass layer 310 of FIG. 3 and FIG. 8A. For example, the glass layer 310 may include transparent glass.

According to an embodiment, the light absorbing layer 1210 may be arranged between the glass layer 310 and a housing 110. According to an embodiment, the light absorbing layer 1210 may include a layer that absorbs light transmitting through the glass layer 310. For example, as the light transmitting through the glass layer 310 is absorbed by the light absorbing layer 1210, only a portion of the light may be reflected by the light absorbing layer 1210.

According to an embodiment, the light absorbing layer 1210 may be formed of a material having a lower reflectance than the glass layer 310. For example, the light absorbing layer 1210 may be formed by an ink method, a painting method, a film coating method, and/or an optically clear adhesive (OCA) method.

According to an embodiment, the light absorbing layer 1210 may block a portion of the light transmitting through the glass layer 310 from being reflected. For example, light incident on the surface of a concave-convex layer 320 may pass through the glass layer 310 and reach the light absorbing layer 1210. Only a portion of the light reaching the light absorbing layer 1210 may be reflected from the light absorbing layer 1210. As the amount of reflected light decreases, the sharpness of an afterimage 1220 of at least one pattern 210 recognized by a user may decrease.

According to an embodiment, as the sharpness of the afterimage 1220 of the at least one pattern 210 decreases, the visibility of the at least one pattern 210 may be improved.

All of the embodiments related to FIGS. 8A to 12 above may be based on FIG. 4A that is a representative figure, and the coupling/combination of respective added features is possible within a range of not contradicting mutually. As an example, the first light transmitting layer 910 may be disposed on the concave-convex layer 320, and the glass layer 310 of FIG. 11A may be disposed beneath the concave-convex layer 320.

The embodiments of FIGS. 3 to 12 described above may be coupled as long as no obvious technical conflict occurs due to the coupling. For example, a feature regarding the concave-convex layer 320 of FIG. 3 may be included in the concave-convex layer 320 of FIGS. 8A to 12. For example, a feature regarding the concave-convex layer 320 including the plurality of grooves 420 of FIG. 4A may be included in the concave-convex layer 320 of FIGS. 8A to 12.

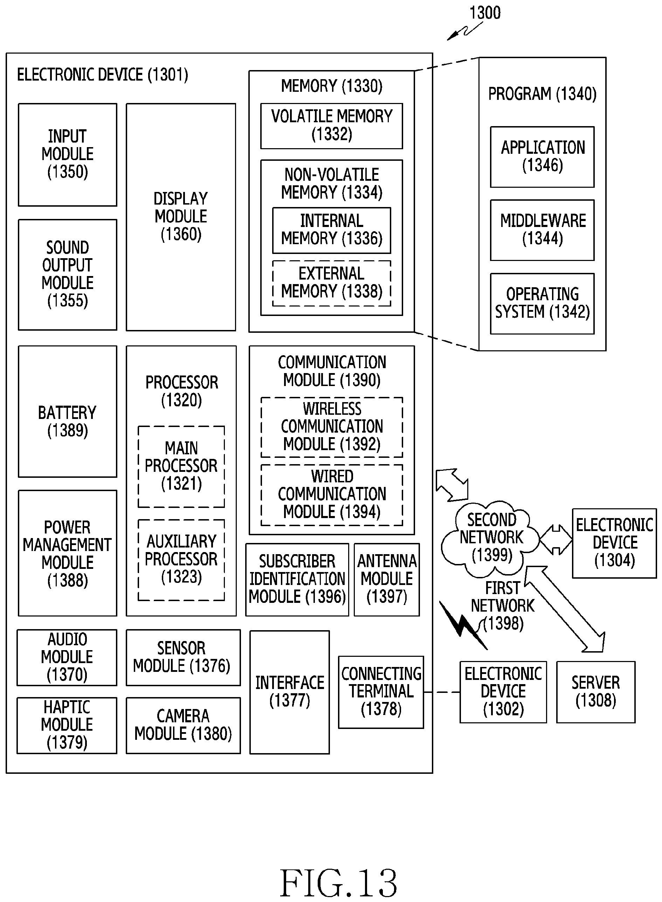

FIG. 13 is a block diagram of an electronic device 1301 (referring to the electronic device 100 of FIG. 1) within a network environment 1300 according to an embodiment.

Referring to FIG. 13, in the network environment 1300, the electronic device 1301 may communicate with an electronic device 1302 through a first network 1398 (e.g., short-distance wireless communication network), or communicate with at least one of an electronic device 1304 or a server 1308 through a second network 1399 (e.g., long-distance wireless communication network). According to an embodiment, the electronic device 1301 may communicate with the electronic device 1304 through the server 1308. According to an embodiment, the electronic device 1301 may include a processor 1320, a memory 1330, an input module 1350, an audio output module 1355, a display module 1360, an audio module 1370, a sensor module 1376, an interface 1377, a connection terminal 1378, a haptic module 1379, a camera module 1380, a power management module 1388, a battery 1389, a communication module 1390, a subscriber identification module 1396, or an antenna module 1397. In some embodiment, in the electronic device 1301, at least one (e.g., connection terminal 1378) of these components may be omitted, or one or more other components may be added. In some embodiment, some (e.g., sensor module 1376, camera module 1380, or antenna module 1397) of these components may be integrated into a single component (e.g., display module 1360).

The processor 1320 may, for example, execute software (e.g., program 1340) and control at least one other component (e.g., hardware or software component) of the electronic device 1301 connected to the processor 1320, and may perform various data processing or operations. According to an embodiment, the processor 1320 may load, as at least part of data processing or operation, a command or data received from other components (e.g., sensor module 1376 or communication module 1390) to a volatile memory 1332, process the command or data stored in the volatile memory 1332, and store the result data in a non-volatile memory 1334. According to an embodiment, the processor 1320 may include a main processor 1321 (e.g., central processing unit or application processor), or an auxiliary processor 1323 (e.g., graphic processing unit, neural processing unit (NPU), image signal processor, sensor hub processor, or communication processor) operable independently from or together with this. For example, when the electronic device 1301 includes the main processor 1321 and the auxiliary processor 1323, the auxiliary processor 1323 may use less power than the main processor 1321, or be set to be specialized for a specified function. The auxiliary processor 1323 may be implemented separately from or as part of the main processor 1321.

The auxiliary processor 1323 may, for example, control at least some of functions or states related to at least one (e.g., display module 1360, sensor module 1376, or communication module 1390) of the components of the electronic device 1301, instead of the main processor 1321 while the main processor 1321 is in an inactive (e.g., sleep) state, or together with the main processor 1321 while the main processor 1321 is in an active (e.g., application running) state. According to an embodiment, the auxiliary processor 1323 (e.g., image signal processor or communication processor) may be implemented as some of other functionally related components (e.g., camera module 1380 or communication module 1390). According to an embodiment, the auxiliary processor 1323 (e.g., neural processing device) may include a hardware structure specialized for processing an artificial intelligence model. The artificial intelligence model may be provided through machine learning. Such learning may be performed, for example, in the electronic device 1301 itself where the artificial intelligence model is performed, or may be performed through a separate server (e.g., server 1308). A learning algorithm may include, for example, supervised learning, unsupervised learning, semi-supervised learning, or reinforcement learning, but is not limited to the above-described example. The artificial intelligence model may include a plurality of artificial neural network layers. An artificial neural network may be one of a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-network or a combination of two or more of the above, but is not limited to the above example. The artificial intelligence model may include, additionally or alternatively, a software structure in addition to a hardware structure.

The memory 1330 may store various data used by at least one component (e.g., processor 1320 or sensor module 1376) of the electronic device 1301. The data may include, for example, software (e.g., program 1340), and input data or output data for a command related to this. The memory 1330 may include the volatile memory 1332 or the non-volatile memory 1334.

The program 1340 may be stored as software in the memory 1330, and may include, for example, an operating system 1342, middleware 1344, or an application 1346.

The input module 1350 may receive a command or data to be used by the component (e.g., processor 1320) of the electronic device 1301 from the outside (e.g., user) of the electronic device 1301. The input module 1350 may include, for example, a microphone, a mouse, a keyboard, a key (e.g., button), or a digital pen (e.g., stylus pen).

The sound output module 1355 may output sound signals to the outside of the electronic device 1301. The sound output module 1355 may include, for example, a speaker or a receiver. The speaker may be used for general purposes such as multimedia playback or record playback. The receiver may be used to receive an incoming call. According to an embodiment, the receiver may be implemented separately from or as part of the speaker.

The display module 1360 may visually present information to the outside (e.g., user) of the electronic device 1301. The display module 1360 may include, for example, a display, a hologram device, or a projector and a control circuit for controlling the corresponding device. According to an embodiment, the display module 1360 may include a touch sensor configured to detect a touch, or a pressure sensor configured to measure the strength of force provided by the touch.

The audio module 1370 may convert a sound into an electrical signal, or conversely convert an electrical signal into a sound. According to an embodiment, the audio module 1370 may acquire a sound through the input module 1350, or output a sound through the sound output module 1355, or an external electronic device (e.g., electronic device 1302) (e.g., speaker or headphone) connected directly or wirelessly to the electronic device 1301.

The sensor module 1376 may detect an operating state (e.g., power or temperature) of the electronic device 1301 or an external environmental state (e.g., user state), and provide an electrical signal or data value corresponding to the detected state. According to an embodiment, the sensor module 1376 may include, for example, a gesture sensor, a gyro sensor, an air pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1377 may support one or more specified protocols that may be used to directly or wirelessly connect the electronic device 1301 to the external electronic device (e.g., electronic device 1302). According to an embodiment, the interface 1377 may include, for example, a high definition multimedia interface (HDMI), a universal serial bus (USB) interface, an SD card interface, or an audio interface.

The connection terminal 1378 may include a connector through which the electronic device 1301 may be physically connected to the external electronic device (e.g., electronic device 1302). According to an embodiment, the connection terminal 1378 may include, for example, an HDMI connector, a USB connector, an SD card connector, or an audio connector (e.g., headphone connector).

The haptic module 1379 may convert an electrical signal into a mechanical stimulus (e.g., vibration or movement) or electrical stimulus that may be perceived by the user through a tactile sense or kinesthetic sense. According to an embodiment, the haptic module 1379 may include, for example, a motor, a piezoelectric element, or an electrical stimulation device.

The camera module 1380 may capture still images and moving images. According to an embodiment, the camera module 1380 may include one or more lenses, image sensors, image signal processors, or flashes.

The power management module 1388 may manage power supplied to the electronic device 1301. According to an embodiment, the power management module 1388 may be implemented as at least part of a power management integrated circuit (PMIC), for example.

The battery 1389 may supply power to at least one component of the electronic device 1301. According to an embodiment, the battery 1389 may include, for example, a non-rechargeable primary battery, a rechargeable secondary battery, or a fuel cell.

The communication module 1390 may support the establishment of a direct (e.g., wired) communication channel or a wireless communication channel between the electronic device 1301 and the external electronic device (e.g., electronic device 1302, electronic device 1304, or server 1308), and communication execution through the established communication channel. The communication module 1390 may include one or more communication processors that operate independently of the processor 1320 (e.g., application processor) and support direct (e.g., wired) communication or wireless communication. According to an embodiment, the communication module 1390 may include a wireless communication module 1392 (e.g., cellular communication module, short-range wireless communication module, or global navigation satellite system (GNSS) communication module) or a wired communication module 1394 (e.g., local area network (LAN) communication module or power line communication module). Among these communication modules, the corresponding communication module may communicate with the external electronic device 1304 through the first network 1398 (e.g., short-range communication network such as Bluetooth, wireless fidelity (WiFi) direct, or infrared data association (IrDA)) or the second network 1399 (e.g., long-range communication network such as a legacy cellular network, a 5G network, a next-generation communication network, the Internet, or a computer network (e.g., LAN or WAN)). These various types of communication modules may be integrated as one component (e.g., single chip), or be implemented as a plurality of separate components (e.g., multiple chips). The wireless communication module 1392 may confirm or authenticate the electronic device 1301 within a communication network such as the first network 1398 or the second network 1399, by using subscriber information (e.g., international mobile subscriber identifier (IMSI)) stored in the subscriber identification module 1396.

The wireless communication module 1392 may support a 5G network and next-generation communication technology beyond a 4G network, for example, a new radio (NR) access technology. The NR access technology may support the high-speed transmission (enhanced mobile broadband (eMBB)) of high-capacity data, the minimization of terminal power and the access (massive machine type communications (mMTC)) of a plurality of terminals, or ultra-reliable and low-latency communications (URLLC). The wireless communication module 1392 may support a high frequency band (e.g., mmWave band) and achieve a high data rate, for example. The wireless communication module 1392 may support various technologies for securing performance in a high frequency band, for example, technologies such as beamforming, massive multiple-input and multiple-output (MIMO), full-dimensional MIMO (FD-MIMO), an array antenna, analog beamforming, or a large scale antenna. The wireless communication module 1392 may support various requirements defined for the electronic device 1301, the external electronic device (e.g., electronic device 1304), or a network system (e.g., second network 1399). According to an embodiment, the wireless communication module 1392 may support a peak data rate (e.g., 20 Gbps or more) for realizing eMBB, a loss coverage (e.g., 164 dB or less) for realizing mMTC, or a U-plane latency (e.g., each downlink (DL) and uplink (UL) of 0.5 ms or less, or round trip of 1 ms or less) for realizing URLLC.

The antenna module 1397 may transmit or receive signals or power to or from the outside (e.g., external electronic device). According to an embodiment, the antenna module 1397 may include an antenna including a radiator that is formed of a conductor or conductive pattern formed on a substrate (e.g., PCB). According to an embodiment, the antenna module 1397 may include a plurality of antennas (e.g., array antenna). In this case, at least one antenna suitable for a communication method used by the communication network such as the first network 1398 or the second network 1399 may be selected from the plurality of antennas by the communication module 1390, for example. A signal or power may be transmitted or received between the communication module 1390 and the external electronic device through the selected at least one antenna. According to some embodiment, in addition to the radiator, other parts (e.g., radio frequency integrated circuit (RFIC)) may be additionally formed as a portion of the antenna module 1397. According to various embodiments, the antenna module 1397 may form a mmWave antenna module. According to an embodiment, the mmWave antenna module may include a printed circuit board, an RFIC disposed on or adjacent to a first surface (e.g., bottom surface) of the printed circuit board and capable of supporting a specified high frequency band (e.g., mmWave band), and a plurality of antennas (e.g., array antenna) disposed on or adjacent to a second surface (e.g., top surface or side surface) of the printed circuit board and capable of transmitting or receiving signals of the specified high frequency band.

At least some of the components may be connected to each other through a communication method (e.g., bus, general purpose input and output (GPIO), serial peripheral interface (SPI), or mobile industry processor interface (MIPI)) between peripheral devices, and exchange signals (e.g., commands or data) with each other.

According to an embodiment, commands or data may be transmitted or received between the electronic device 1301 and the external electronic device 1304 through the server 1308 connected to the second network 1399. The external electronic device 1302 or 1304 each may include a device of the same or different type from the electronic device 1301. According to an embodiment, all or some of the operations performed by the electronic device 1301 may be executed by one or more of the external electronic devices 1302, 1304 or 1308. For example, when the electronic device 1301 needs to perform a certain function or service automatically or in response to a request from the user or another device, the electronic device 1301 may request one or more external electronic devices to perform at least part of the function or service, instead of or additionally to executing the function or service on its own. The one or more external electronic devices receiving the request may execute at least part of the requested function or service or an additional function or service related to the request, and transmit the execution result to the electronic device 1301. The electronic device 1301 may present the result as at least part of a response to the request, as it is or after additional processing. For this purpose, for example, cloud computing, distributed computing, mobile edge computing (MEC), or client-server computing technology may be used. The electronic device 1301 may present an ultra-low latency service by using, for example, distributed computing or mobile edge computing. In another embodiment, the external electronic device 1304 may include an Internet of things (IoT) device. The server 1308 may include an intelligent server that uses machine learning and/or a neural network. According to an embodiment, the external electronic device 1304 or the server 1308 may be included in the second network 1399. The electronic device 1301 may be applied to an intelligent service (e.g., smart home, smart city, smart car, or healthcare), based on a 5G communication technology and an IoT related technology.

The electronic device of various embodiments disclosed in this document may include various types of devices. The electronic device may include, for example, a portable communication device (e.g., smartphone), a computer device, a portable multimedia device, a portable medical device, a camera, a wearable device, or a home appliance. The electronic device of an embodiment of this document is not limited to the above-described devices.

Various embodiments of this document and terms used herein are not intended to limit the technical features described in this document to specific embodiments, but should be understood as including various modifications, equivalents, or alternatives of the corresponding embodiment. In relation to the description of the drawings, similar reference numerals may be used for similar or related components. The singular form of a noun corresponding to an item may include a single or plurality of items, unless the relevant context clearly indicates otherwise. In this document, each of phrases such as "A or B", "at least one of A and B", "at least one of A or B", "A, B or C", "at least one of A, B and C", and "at least one of A, B, or C" may include any one of items listed together in the corresponding phrase among the phrases, or any possible combination thereof. Terms such as "first", "second", "firstly" or "secondly" may be used simply to distinguish a corresponding component from another corresponding component, and do not limit the corresponding components in other respects (e.g., importance or order). When some (e.g., first) component is mentioned to be "coupled" or "connected" to another (e.g., second) component, with or without the term "functionally" or "communicatively", it means that some component may be connected to another component directly (e.g., wired), wirelessly, or through a third component.

The term "module" used in the various embodiments of this document may include a unit implemented in hardware, software, or firmware, and may be used interchangeable with a term such as a logic, a logic block, a component, or a circuit, for example. The module may include an integrated component, or a minimum unit of the component or part thereof, performing one or more functions. For example, according to an embodiment, the module may be implemented in the form of an application-specific integrated circuit (ASIC).

Various embodiments of this document may be implemented as software (e.g., program 1340) that includes one or more instructions stored in a machine (e.g., electronic device 1301) - readable storage medium (e.g., internal memory 1336 or external memory 1338). For example, a processor (e.g., processor 1320) of the machine (e.g., electronic device 1301) may call at least one instruction among the stored one or more instructions from the storage medium, and execute it. This enables the machine to be operated to perform at least one function according to the called at least one instruction. The one or more instructions may include a code provided by a compiler or a code executable by an interpreter. The machine-readable storage medium may be presented in the form of a non-transitory storage medium. Here, 'non-transitory' only means that the storage medium is a tangible device and does not include a signal (e.g., electromagnetic wave). This term does not distinguish a case where data is stored semi-permanently in the storage medium from a case where data is stored temporarily.

According to an embodiment, a method of various embodiments disclosed in this document may be included and presented in a computer program product. The computer program product may be traded as merchandise between a seller and a buyer. The computer program product may be distributed in the form of a machine-readable storage medium (e.g., compact disc read only memory (CD-ROM)), or may be distributed (e.g., downloaded or uploaded) through an application store (e.g., Play Store^{™}), directly between two user devices (e.g., smartphones), or online. In the online distribution, at least part of the computer program product may be at least temporarily stored in the machine-readable storage medium such as a memory of a manufacturer's server, an application store's server, or a relay server, or be temporarily provided.

According to various embodiments, each component (e.g., module or program) of the above-described components may include a single or plurality of entities, and some of the plurality of entities may be also separately arranged in another component. According to various embodiments, one or more components of the corresponding components mentioned above or operations may be omitted, or one or more other components or operations may be added. Additionally or alternatively, a plurality of components (e.g., modules or programs) may be integrated into one component. In this case, the integrated component may perform one or more functions of each of the plurality of components, identically or similarly to those performed by the corresponding component among the plurality of components prior to the integration. According to various embodiments, operations performed by the module, the program, or other component may be executed sequentially, in parallel, iteratively, or heuristically, or one or more of the operations may be executed in a different order or be omitted, or one or more other operations may be added.

According to an embodiment, an electronic device may include a housing. According to an embodiment, the electronic device may include a glass layer formed on a rear surface of the housing. According to an embodiment, the electronic device may include a concave-convex layer formed on the glass layer and including a plurality of grooves. According to an embodiment, a nano-second laser beam may be radiated to partial grooves among the plurality of grooves, thereby carving at least one pattern on the concave-convex layer. According to an embodiment, the radiated nano-second laser beam may be multi-reflected and multi-absorbed on the inner walls of the partial grooves among the plurality of grooves.

According to an embodiment, the nano-second laser beam may include a wavelength in a range of 350 nanometer (nm) to 1 millimeter (mm). According to an embodiment, each of the partial grooves among the plurality of grooves may have a first width corresponding to the wavelength of the nano-second laser and a first height corresponding to the wavelength of the nano-second laser.

According to an embodiment, the first width may include a range of 350 nm to 1 mm. According to an embodiment, the first height may include a range of 350 nm to 1 mm.

According to an embodiment, the concave-convex layer may include a first area where the nano-second laser beam is radiated and the at least one pattern is carved and a second area where the at least one pattern is not carved.

According to an embodiment, a first illuminance of the first area may be higher than a second illuminance of the second area.

According to an embodiment, the glass layer may be formed of transparent glass. According to an embodiment, the electronic device may further include a color layer arranged between the housing and the glass layer.

According to an embodiment, the glass layer may be formed of transparent glass. According to an embodiment, the electronic device may further include a color layer disposed on the concave-convex layer.

According to an embodiment, the electronic device may further include a first light transmitting layer which is disposed on the concave-convex layer and has a lower light transmittance than the glass layer.

According to an embodiment, the glass layer may be formed of transparent glass. According to an embodiment, the electronic device may further include a light absorbing layer arranged between the housing and the glass layer and having a lower reflectance than the glass layer.

According to an embodiment, the glass layer may have a light transmittance in a range of 0 % to 90 %.

According to an embodiment, the glass layer may be formed of transparent glass. According to an embodiment, the electronic device may further include a second light transmitting layer arranged between the housing and the glass layer and having substantially the same light transmittance as the glass layer.

According to an embodiment, the concave-convex layer may include a heat affected zone formed around the at least one pattern carved by the nano-second laser beam.

According to an embodiment, the concave-convex layer may be formed through a chemical etching process, a blasting process, or a dry etching process that uses ion plasma.

According to an embodiment, a method for forming a pattern on a housing of an electronic device may include preparing a glass layer formed on the housing. According to an embodiment, the method for forming the pattern on the housing of the electronic device may include forming a concave-convex layer including a plurality of grooves on the glass layer. According to an embodiment, the method for forming the pattern on the housing of the electronic device may include radiating a nano-second laser beam to the plurality of grooves and forming at least one pattern on the concave-convex layer. According to an embodiment, the at least one pattern may be formed by the nano-second laser beam multi-reflected and multi-absorbed on an inner wall of each of partial grooves among the plurality of grooves.

According to an embodiment, the nano-second laser beam may include a wavelength in a range of 350 nanometer (nm) to 1 millimeter (mm). According to an embodiment, each of the partial grooves among the plurality of grooves may have a first width corresponding to the wavelength of the nano-second laser and a first height corresponding to the wavelength of the nano-second laser.

According to an embodiment, the first width may include a range of 350 nm to 1 mm. According to an embodiment, the first height may include a range of 350 nm to 1 mm.

According to an embodiment, the concave-convex layer may include a first area where the nano-second laser beam is radiated and the at least one pattern is carved and a second area where the at least one pattern is not carved.

According to an embodiment, a first illuminance of the first area may be higher than a second illuminance of the second area.

According to an embodiment, the method may further include arranging a color layer arranged between the housing and a glass layer, before preparing the glass layer formed on the housing.

According to an embodiment, the method may further include a method of arranging a first light transmitting layer arranged between the housing and a glass layer, before preparing the glass layer formed on the housing.

According to an embodiment, the method may further include a method of further arranging a light absorbing layer arranged between the housing and a glass layer and having a lower reflectance than the glass layer, before preparing the glass layer formed on the housing.

According to an embodiment, the glass layer may have a light transmittance in a range of 0 % to 90 %.

## Claims

1. An electronic device comprising:
a housing;
a glass layer formed on a rear surface of the housing; and
a concave-convex layer formed on the glass layer and comprising a plurality of grooves,
wherein a nano-second laser beam is radiated to partial grooves among the plurality of grooves and at least one pattern is carved on the concave-convex layer, and
the radiated nano-second laser beam is multi-reflected and multi-absorbed on the inner walls of the partial grooves among the plurality of grooves.

2. The electronic device of claim 1, wherein the nano-second laser beam comprises a wavelength in a range of 350 nanometer (nm) to 1 millimeter (mm), and
each of the partial grooves among the plurality of grooves has a first width corresponding to the wavelength of the nano-second laser and a first height corresponding to the wavelength of the nano-second laser.

3. The electronic device of claim 2, wherein the first width comprises a range of 350 nm to 1 mm, and
the first height comprises a range of 350 nm to 1 mm.

4. The electronic device of claim 1, wherein the concave-convex layer comprises a first area where the nano-second laser beam is radiated and the at least one pattern is carved and a second area where the at least one pattern is not carved, and
a first illuminance of the first area is higher than a second illuminance of the second area.

5. The electronic device of claim 1, wherein the glass layer is formed of transparent glass, and
the electronic device further comprises a color layer arranged between the housing and the glass layer.

6. The electronic device of claim 1, wherein the glass layer is formed of transparent glass, and
the electronic device further comprises a color layer disposed on the concave-convex layer.

7. The electronic device of claim 1, further comprising a first light transmitting layer which is disposed on the concave-convex layer and has a lower light transmittance than the glass layer.

8. The electronic device of claim 1, wherein the glass layer is formed of transparent glass, and
the electronic device further comprises a light absorbing layer arranged between the housing and the glass layer and having a lower reflectance than the glass layer.

9. The electronic device of claim 1, wherein the glass layer has a light transmittance in a range of 0 % to 90 %.

10. The electronic device of claim 1, wherein the glass layer is formed of transparent glass, and
the electronic device further comprises a second light transmitting layer arranged between the housing and the glass layer and having substantially the same light transmittance as the glass layer.

11. The electronic device of claim 1, wherein the concave-convex layer comprises a heat affected zone formed around the at least one pattern carved by the nano-second laser beam.

12. The electronic device of claim 1, wherein the concave-convex layer is formed through a chemical etching process, a blasting process, or a dry etching process that uses ion plasma.

13. A method for forming a pattern on a housing of an electronic device, comprising:
preparing a glass layer formed on the housing;
forming a concave-convex layer comprising a plurality of grooves on the glass layer; and
radiating a nano-second laser beam to the plurality of grooves and forming at least one pattern on the concave-convex layer,
wherein the at least one pattern is formed by the nano-second laser beam multi-reflected and multi-absorbed on an inner wall of each of partial grooves among the plurality of grooves.

14. The method of claim 13, wherein the nano-second laser beam comprises a wavelength in a range of 350 nanometer (nm) to 1 millimeter (mm), and
each of the partial grooves among the plurality of grooves has a first width corresponding to the wavelength of the nano-second laser and a first height corresponding to the wavelength of the nano-second laser.

15. The method of claim 13, wherein the concave-convex layer comprises a first area where the nano-second laser beam is radiated and the at least one pattern is carved and a second area where the at least one pattern is not carved, and
a first illuminance of the first area is higher than a second illuminance of the second area.
